# EUROPEAN PATENT SPECIFICATION

(11) **EP 4 391 253 B1**
(45) Date of publication and mention of the grant of the patent: **01.10.2025**
(21) Application number: 22860834.5
(22) Date of filing: 09.03.2022
(51) Int. Cl.: H01S 5/183, H01S 5/187, H01S 5/042, H01S 5/30, H01S 5/20, H01S 5/343

(54) **SURFACE LIGHT EMITTING ELEMENT, AND METHOD FOR MANUFACTURING SURFACE LIGHT EMITTING ELEMENT**
OBERFLÄCHENLICHTEMITTIERENDES ELEMENT UND VERFAHREN ZUR HERSTELLUNG DES OBERFLÄCHENLICHTEMITTIERENDEN ELEMENTS
ÉLÉMENT ÉLECTROLUMINESCENT DE SURFACE, ET PROCÉDÉ DE FABRICATION D'ÉLÉMENT ÉLECTROLUMINESCENT DE SURFACE

(30) Priority: 26.08.2021 JP 2021138210
(43) Date of publication of application: 26.06.2024
(73) Proprietor: Sony Group Corporation, Tokyo 108-0075 (JP)
(72) Inventor: YOKOZEKI, Mikihiro, Tokyo 108-0075 (JP); NAKAJIMA, Hiroshi, Tokyo 108-0075 (JP); KASAHARA, Daiji, Tokyo 108-0075 (JP); SHIOMI, Michinori, Tokyo 108-0075 (JP); WATANABE, Tomomasa, Tokyo 108-0075 (JP); TANAKA, Masayuki, Tokyo 108-0075 (JP)
(74) Representative: D Young & Co LLP
(86) International application number: PCT/JP2022/010412
(87) International publication number: WO 2023/026536

(56) References cited:
- WO-A1-2021/024508
- WO-A1-2021/024508
- JP-A- 2009 038 310
- JP-A- 2010 080 571
- JP-A- 2013 175 712
- US-A1- 2001 050 934
- US-A1- 2009 305 447
- US-A1- 2020 112 140
- KOYAMA, FUMIO: "Latest Progress in Surface Emitting Devices: Low-Thresholding of Surface Emitting Devices", KOGAKU - JAPANESE JOURNAL OF OPTICS, OYO BUTSURI GAKKAI. KOGAKU KONWAKAI, TOKYO, JP, vol. 27, no. 10, 30 September 1998 (1998-09-30), JP , pages 560 - 565, XP009543741, ISSN: 0389-6625

## Description

### Technical Field

The present disclosure relates to a surface emitting device and a method for manufacturing the surface emitting device.

### Background Art

NPL 1 and PTL 1 disclose a vertical cavity surface emitting laser (VCSEL) as a surface emitting device. In the surface emitting device, AlAs/GaAs distributed bragg reflector 'DBR) substrates are bonded to an upper side and a lower side of an InP active layer, and a reflector is formed with the DBR substrate.

According to the surface emitting device configured in this way, because the DBR substrate has excellent heat dissipation, it is possible to obtain excellent characteristics.

### Citation List

### Patent Literature

NPL 1: Andrei Caliman. Et al. "8 mW fundamental mode output of wafer fused VCSELs emitting in the 1550-nm band.", OPTICS EXPRESS, Vol. 19, No. 18, pp. 16996-17001, 29 August 2011
PTL 1: Japanese Unexamined Patent Application Publication No. 2008-283053

Cited references include US 2020/112140 A1 and WO 2021/024508 A1.

### Summary of the Invention

The surface emitting device adopts a buried tunnel junction (BTJ) structure. In the buried tunnel junction structure, a current is controlled, and optical confinement is controlled.

By the way, to lower a voltage in the buried tunnel junction structure, a semiconductor material and a doping concentration are limited, and it is difficult to freely control the optical confinement. Therefore, the surface emitting device is desired to achieve both of the current control and the optical confinement control.

The invention is defined by the claims.

### Brief Description of Drawing

[FIG. 1] FIG. 1 is a main portion cross-sectional diagram (cross-sectional diagram taken along A-A cut line illustrated in FIG. 2) of a surface emitting device according to a first embodiment of the present disclosure.
[FIG. 2] FIG. 2 is a main portion plan view of the surface emitting device illustrated in FIG. 1.
[FIG. 3] FIG. 3 is a first process cross-sectional diagram that describes a method for manufacturing the surface emitting device according to the first embodiment.
[FIG. 4] FIG. 4 is a second process cross-sectional diagram.
[FIG. 5] FIG. 5 is a third process cross-sectional diagram.
[FIG. 6] FIG. 6 is a fourth process cross-sectional diagram.
[FIG. 7] FIG. 7 is a fifth process cross-sectional diagram.
[FIG. 8] FIG. 8 is a sixth process cross-sectional diagram.
[FIG. 9] FIG. 9 is a seventh process cross-sectional diagram.
[FIG. 10] FIG. 10 is an eighth process cross-sectional diagram.
[FIG. 11] FIG. 11 is a ninth process cross-sectional diagram.
[FIG. 12] FIG. 12 is a main portion cross-sectional diagram (cross-sectional diagram taken along B-B cut line illustrated in FIG. 13) of a surface emitting device according to a second embodiment of the present disclosure, corresponding to FIG. 1.
[FIG. 13] FIG. 13 is a main portion plan view of the surface emitting device illustrated in FIG. 12, corresponding to FIG. 2.
[FIG. 14] FIG. 14 is a main portion cross-sectional diagram (cross-sectional diagram taken along C-C cut line illustrated in FIG. 15) of a surface emitting device according to a third embodiment of the present disclosure, corresponding to FIG. 1.
[FIG. 15] FIG. 15 is a main portion plan view of the surface emitting device illustrated in FIG. 14, corresponding to FIG. 2.
[FIG. 16] FIG. 16 is a main portion cross-sectional diagram (cross-sectional diagram taken along D-D cut line illustrated in FIG. 17) of a surface emitting device according to a fourth embodiment of the present disclosure, corresponding to FIG. 1.
[FIG. 17] FIG. 17 is a main portion plan view of the surface emitting device illustrated in FIG. 16, corresponding to FIG. 2.
[FIG. 18] FIG. 18 is a main portion cross-sectional diagram (cross-sectional diagram taken along E-E cut line illustrated in FIG. 19) of a surface emitting device according to a fifth embodiment of the present disclosure, corresponding to FIG. 1.
[FIG. 19] FIG. 19 is a main portion plan view of the surface emitting device illustrated in FIG. 18, corresponding to FIG. 2.
[FIG. 20] FIG. 20 is a main portion cross-sectional diagram (cross-sectional diagram taken along F-F cut line illustrated in FIG. 21) of a surface emitting device according to a sixth embodiment of the present disclosure, corresponding to FIG. 1.
[FIG. 21] FIG. 21 is a main portion plan view of the surface emitting device illustrated in FIG. 20, corresponding to FIG. 2.
[FIG. 22] FIG. 22 is a main portion cross-sectional diagram (cross-sectional diagram taken along G-G cut line illustrated in FIG. 23) of a surface emitting device according to a seventh embodiment of the present disclosure, corresponding to FIG. 1.
[FIG. 23] FIG. 23 is a main portion plan view of the surface emitting device illustrated in FIG. 22, corresponding to FIG. 2.
[FIG. 24] FIG. 24 is a main portion cross-sectional diagram (cross-sectional diagram taken along H-H cut line illustrated in FIG. 25) of a surface emitting device according to an eighth embodiment of the present disclosure, corresponding to FIG. 1.
[FIG. 25] FIG. 25 is a main portion plan view of the surface emitting device illustrated in FIG. 24, corresponding to FIG. 2.
[FIG. 26] FIG. 26 is a main portion plan view of a surface emitting device according to a ninth embodiment of the present disclosure, corresponding to FIG. 2.
[FIG. 27] FIG. 27 is a main portion cross-sectional diagram of a surface emitting device according to a tenth embodiment of the present disclosure, corresponding to FIG. 1.

### Modes for Carrying Out the Invention

In the following, embodiments of the present disclosure are described in detail with reference to the drawings. It is to be noted that the description is given in the following order.

### 1. First Embodiment

In a first embodiment, an example in which the present technology is applied to a surface emitting device is described. Here, a basic structure and a manufacturing method of the surface emitting device are described.

### 2. Second Embodiment

In a second embodiment, a first example in which an electrode structure is changed in the surface emitting device according to the first embodiment is described.

### 3. Third Embodiment

In a third embodiment, an example in which the present technology is applied to another reflection layer in the surface emitting device according to the second embodiment is described.

### 4. Fourth Embodiment

In a fourth embodiment, a modification example of a mesa shape of the reflection layer in the surface emitting device according to the third embodiment is described.

### 5. Fifth Embodiment

In a fifth embodiment, a second example in which an electrode structure is changed in the surface emitting device according to the first embodiment is described.

### 6. Sixth Embodiment

In a sixth embodiment, an example is described in which a reflection layer different from the reflection layer, to which the present technology is applied, includes a dielectric material, in the surface emitting device according to the third embodiment.

### 7. Seventh Embodiment

In a seventh embodiment, an application example in which the surface emitting device according to the fifth embodiment and the surface emitting device according to the sixth embodiment are combined is described.

### 8. Eighth Embodiment

In an eighth embodiment, an application example in which the surface emitting device according to the fourth embodiment and the surface emitting device according to the sixth embodiment are combined is described.

### 9. Ninth Embodiment

In a ninth embodiment, a modification example of a mesa shape of a reflection layer in the surface emitting device according to the eighth embodiment is described.

### 10. Tenth Embodiment

In a tenth embodiment, a modification example of a tunnel junction layer in the surface emitting device according to the first embodiment is described.

### 11. Other Embodiments

### <1. First Embodiment>

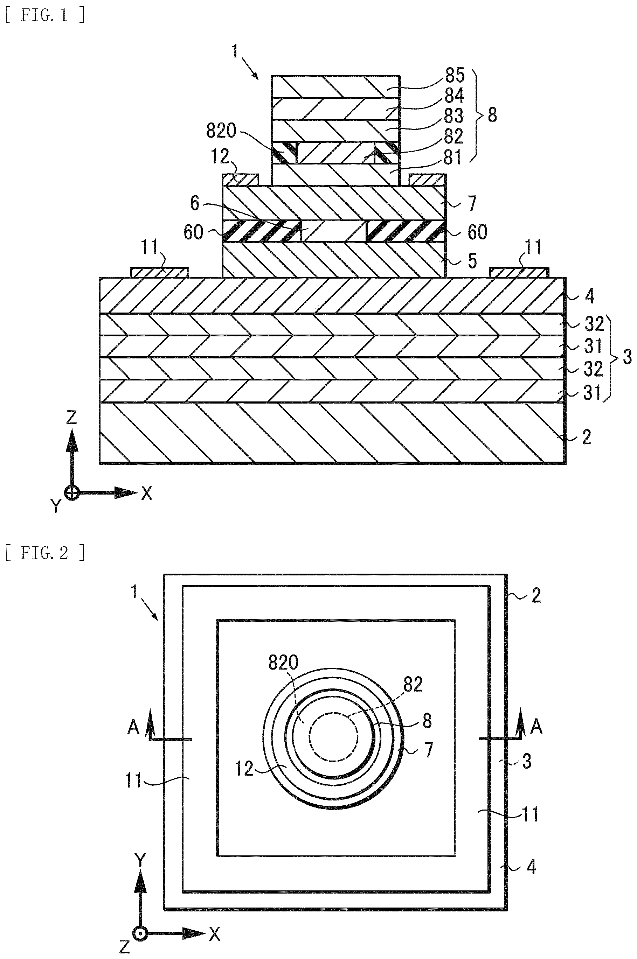

A surface emitting device 1 and a method for manufacturing the surface emitting device 1 according to a first embodiment of the present disclosure are described with reference to FIGs. 1 to 11.

Here, an arrow X direction illustrated in the drawings appropriately indicates a single planar direction of the surface emitting device 1 placed on a plane for convenience. An arrow Y direction indicates another single planar direction orthogonal to the arrow X direction. Furthermore, an arrow Z direction indicates an upward direction orthogonal to the arrow X direction and the arrow Y direction. That is, the arrow X direction, the arrow Y direction, and the arrow Z direction exactly and respectively match an X axis direction, a Y axis direction, and a Z axis direction in a three-dimensional coordinate system.

Note that each of these directions is illustrated for easy understanding of description and does not limit a direction of the present technology.

### [Configuration of Surface Emitting Device 1]

### (1) Overall Configuration of Surface Emitting Device 1

FIG. 1 illustrates an example of a longitudinal cross section configuration of the surface emitting device 1. Furthermore, FIG. 2 illustrates an example of a plane configuration of the surface emitting device 1.

The surface emitting device 1 includes a first reflection layer 3, a first semiconductor layer 4, a light emission layer 5, a second semiconductor layer 7, and a second reflection layer 8 laminated on a substrate 2 in order. A tunnel junction layer 6 is formed between the light emission layer 5 and the second semiconductor layer 7.

In the first embodiment, the substrate 2, the first reflection layer 3, and the first semiconductor layer 4 are formed in a rectangular shape as viewed from the arrow Z direction (hereinafter, simply referred to as "in planar view"). The light emission layer 5, the tunnel junction layer 6, and the second semiconductor layer 7 are formed in a mesa shape and is formed in a circular shape smaller than a plane size of the substrate 2 or the like in planar view. Then, the second reflection layer 8 is formed in a mesa shape and is formed in a circular shape one size smaller than a plane size of the light emission layer 5 or the like.

Note that, because a current constriction region 60 is formed around the tunnel junction layer 6, the current constriction region 60 is actually formed in a mesa shape.

Moreover, the surface emitting device 1 includes a first electrode 11 and a second electrode 12. The first electrode 11 is formed on the first semiconductor layer 4. Here, the first electrode 11 is laminated on the first semiconductor layer 4 and is used as a cathode electrode. The second electrode 12 is formed on the second semiconductor layer 7. Here, the second electrode 12 is laminated on the second semiconductor layer 7 and is used as an anode electrode.

### (2) Configuration of Substrate 2

The substrate 2 is used as a epitaxial growth substrate. For example, GaAs is used for the substrate 2.

### (3) Configuration of First Reflection Layer 3

The first reflection layer 3 is formed on the substrate 2. The first reflection layer 3 includes a second crystal material of which a lattice constant, a crystal structure, or both are different from a first crystal material of the first semiconductor layer 4 to be described later.

Here, the second crystal material is, for example, AlGaAs and GaAs having higher heat dissipation than the first crystal material. The first reflection layer 3 is formed by repeatedly laminating a plurality of AlGaAs layers 31 and a plurality of GaAs layers 32. That is, the first reflection layer 3 is formed as an AlGaAs/GaAs DBR (semiconductor DBR).

Note that the first reflection layer 3 may be formed by interposing a buffer layer on the substrate 2.

### (4) Configuration of First Semiconductor Layer 4

The first semiconductor layer 4 is formed on the first reflection layer 3. The first semiconductor layer 4 is used as a cladding layer. The first semiconductor layer 4 includes the first crystal material. Here, as the first crystal material, n-type InP is used. InP is a luminescence material in a 1.31 µm band and a 1.55 µm band that are low loss bands of an optical fiber and has excellent luminous characteristics. Therefore, it is possible to use InP as a luminescence material of an optical communication laser device.

A thickness of the first semiconductor layer 4 is formed to be equal to or more than 100 nm and equal to or less than 1,000 nm, for example. For an n-type impurity to be doped to InP, for example, Si is used.

### (5) Configuration of Light Emission Layer 5

The light emission layer (or active layer) 5 is formed on the first semiconductor layer 4. The light emission layer 5 has a structure in which a plurality of barrier layers and a plurality of quantum well layers are alternately laminated.

For example, AlGaInAs is used for the barrier layer.

The quantum well layer includes at least one element selected from among Al, Ga, and In that are group III elements and at least one element selected from among As, P, and N that are group V elements. Here, the quantum well layer includes, for example, non-doped AlGaInAs as a main component.

Furthermore, a quantum wire or a quantum dot may be used as the quantum well layer. Moreover, in the first embodiment, the light emission layer 5 may be configured as a distortion compensation quantum well.

### (6) Configuration of Tunnel Junction Layer 6

The tunnel junction layer 6 is formed on the light emission layer 5. The tunnel junction layer 6 is formed in a middle portion of the mesa shape, and is formed, for example, in a circular shape in planar view.

Here, the tunnel junction layer 6 includes, for example, p-type AlInAs and n-type InP laminated on AlInAs. As a p-type impurity doped to AlInAs, for example, C is used. As an n-type impurity doped to InP, for example, Si is used.

The current constriction region 60 is formed around the tunnel junction layer 6. In the first embodiment, the current constriction region 60 is formed by doping into the tunnel junction layer 6 using an ion implantation method. Note that the current constriction region 60 is formed after the second semiconductor layer 7 has been formed. As the impurity, for example, proton (H+) is used. Furthermore, current constriction may be performed with a buried tunnel junction structure.

### (7) Configuration of Second Semiconductor Layer 7

The second semiconductor layer 7 is formed on the tunnel junction layer 6 and on the current constriction region 60. The second semiconductor layer 7 is used as a cladding layer. The second semiconductor layer 7 includes the first crystal material, similarly to the first semiconductor layer 4. Here, as the first crystal material, n-type InP is used.

A thickness of the first semiconductor layer 4 is not particularly limited, but is formed to be equal to or more than 100 nm and equal to or less than 1,000 nm, for example. As the n-type impurity doped to InP, for example, Si is used.

### (8) Configuration of Second Reflection Layer 8

The second reflection layer 8 is formed on the second semiconductor layer 7. The second reflection layer 8 includes the second crystal material of which the lattice constant, the crystal structure, or both are different from the first crystal material of the second semiconductor layer 7, similarly to the first reflection layer 3.

Here, the second crystal material is, for example, GaAs, AlAs, and AlGaAs. More specifically, the second reflection layer 8 is formed by laminating each of a GaAs layer 81, an AlAs layer 82, a GaAs layer 83, an AlGaAs layer 84, and a GaAs layer 85 in order. That is, the second reflection layer 8 is configured as an AlGaAs DBR (semiconductor DBR).

The GaAs layer 81 is formed to have a thickness of about λ / 4n (n is refractive index of material) that varies depending on a laser wavelength. For example, in a case where an oscillation wavelength is set to 1,550 nm, the GaAs layer 81 is formed to have a thickness, for example, equal to or more than 100 nm and equal to or less than 200 nm. The AlAs layer 82 is formed to have a thickness, for example, equal to or more than 10 nm and equal to or less than 50 nm. The GaAs layer 83 is formed to have a thickness, for example, equal to or more than 100 nm and equal to or less than 200 nm. The AlGaAs layer 84 is formed to have a thickness, for example, equal to or more than 100 nm and equal to or less than 150 nm. The GaAs layer 85 is formed to have a thickness, for example, equal to or more than 80 nm and equal to or less than 130 nm. Then, a thickness of the entire second reflection layer 8 is formed to be a thickness, for example, equal to or more than five µm and equal to or less than 10 µm.

### (9) Configuration of Light Constriction Region 820

The surface emitting device 1 according to the first embodiment has a light constriction region 820 that is independently optimized with respect to the current constriction region 60. The light constriction region 820 is formed in a portion of the second reflection layer 8.

More specifically, the light constriction region 820 is a region formed by oxidizing the AlAs layer 82, exposed from a side surface of the mesa shape, toward inside of the mesa shape. That is, the light constriction region 820 includes AlOₓ. In the light constriction region 820, it is possible to control optical confinement.

Here, the light constriction region 820 is formed by oxidization across an entire region around the side surface of the mesa shape. Therefore, the AlAs layer 82 to be a light transmission region is formed in a circular shape one size smaller than the mesa shape in planar view. It is possible to set a diameter of the circular shape of the AlAs layer 82 to be an optimal value independent from a diameter of the tunnel junction layer 6 of which a peripheral shape is defined by the current constriction region 60. In the first embodiment, the diameter of the AlAs layer 82 is formed to be equal to or more than five µm and equal to or less than 20 µm, for example, and is formed to be a value equivalent to the diameter of the tunnel junction layer 6.

Moreover, the light constriction region 820 is arranged at a position separated from the light emission layer 5 by one cycle of a laminated structure of the second reflection layer 8 or more. Here, the light constriction region 820 is separated from the light emission layer 5, by interposing at least the GaAs layer 81 of the second reflection layer 8. For example, although a separation distance between the light constriction region 820 and the light emission layer 5 depends on the oscillation wavelength, for example, the separation distance is set to be equal to or more than 300 nm, for example, with a wavelength of equal to or more than 1.3 µm and equal to or less than 1.6 µm.

### (10) Configuration of First Electrode 11

The first electrode 11 is formed on the first semiconductor layer 4. Specifically, the first electrode 11 is formed on a surface along a circumference end of the first semiconductor layer 4, around the mesa shape of the light emission layer 5, the tunnel junction layer 6, and the second semiconductor layer 7. Although the shape is not specified, here, the first electrode 11 is formed in a rectangular ring shape having the same width dimension in planar view. The first electrode 11 is constructed by an intra-cavity structure in which an electrode is formed in the first semiconductor layer 4 arranged under the light emission layer 5.

### (11) Configuration of Second Electrode 12

The second electrode 12 is formed on the second semiconductor layer 7. Specifically, the second electrode 12 is formed on a surface along a circumference end of the second semiconductor layer 7, around the mesa shape of the second reflection layer 8. The shape is not specified similarly to the first electrode 11. However, here, the second electrode 12 is formed in a circular ring shape having the same width dimension in planar view.

### [Method for Manufacturing Surface Emitting device 1]

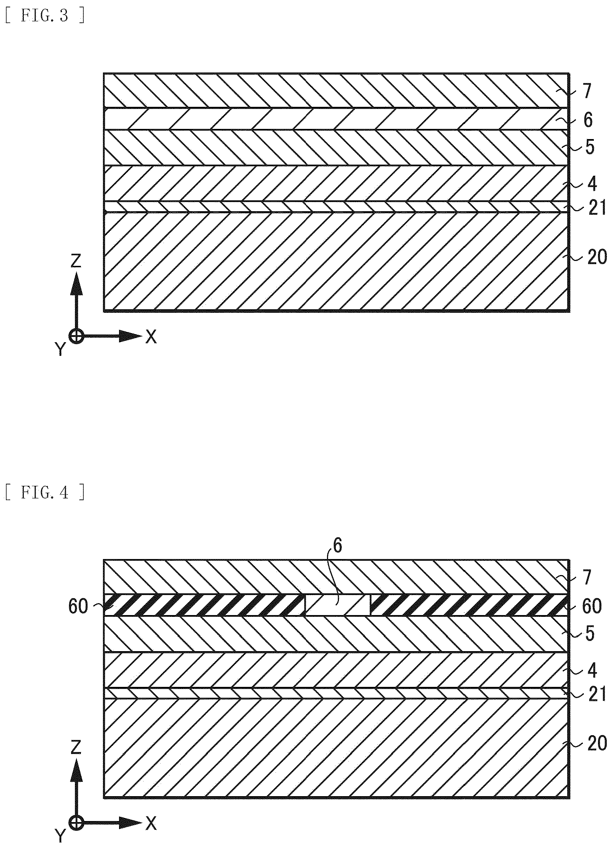

Next, a method for manufacturing the surface emitting device is described. FIGs. 3 to 11 illustrate cross-sectional configurations respectively illustrating processes of a method for manufacturing the surface emitting device 1 according to the first embodiment.

First, an epitaxial growth substrate 20 is prepared (refer to FIG. 3). For the epitaxial growth substrate 20, for example, n-type InP is used as the first crystal material.

As illustrated in FIG. 3, an etching stop layer 21 is interposed on the epitaxial growth substrate 20, and the first semiconductor layer 4, the light emission layer 5, the tunnel junction layer 6, and the second semiconductor layer 7 are laminated and formed in order. For the etching stop layer 21, for example, InGaAsP is used.

As illustrated in FIG. 4, the current constriction region 60 is formed around the tunnel junction layer 6. The current constriction region 60 is formed by doping into the tunnel junction layer 6 through the second semiconductor layer 7, using the ion implementation method.

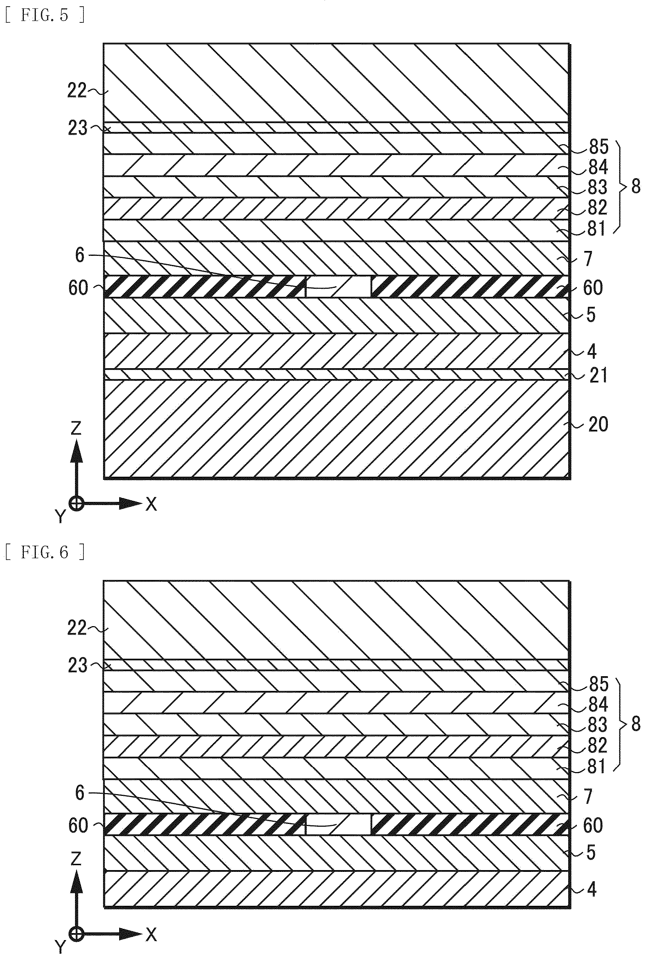

As illustrated in FIG. 5, the second reflection layer 8 is formed on the second semiconductor layer 7. The second reflection layer 8 is laminated above a substrate 22 as interposing an etching stop layer 23 therebetween. That is, the GaAs layer 85, the AlGaAs layer 84, the p-type GaAs layer 83, the AlAs layer 82, and the GaAs layer 81 are laminated and formed on the substrate 2 in order.

For the substrate 22, for example, a GaAs substrate is used. For the etching stop layer 23, for example, InGaP is used. The second semiconductor layer 7 and the GaAs layer 81 of the second reflection layer 8 are bonded. Although a bonding method is not particularly limited, a normal temperature bonding method using plasma, an atomic diffusion bonding method using oxidization, or the like is used for bonding. With these bonding methods, it is possible to reduce light absorption at a bonded interface.

As illustrated in FIG. 6, the epitaxial growth substrate 20 is polished, and in addition, the epitaxial growth substrate 20 and the etching stop layer 21 are removed using wet etching. As a result, a rear surface of the first semiconductor layer 4 is planarized.

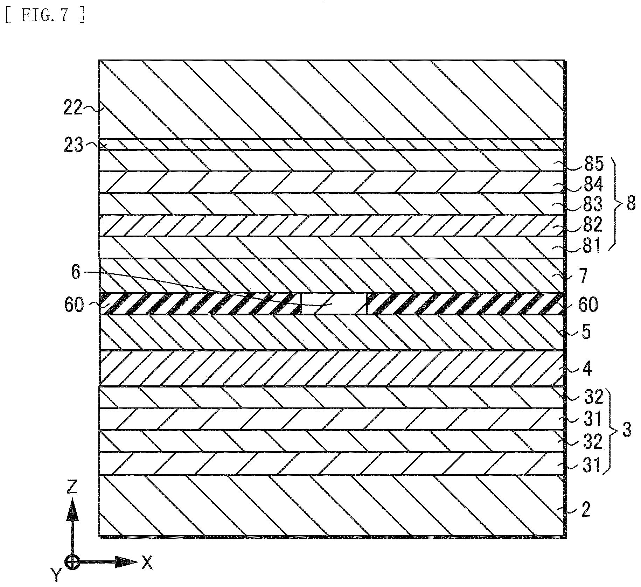

As illustrated in FIG. 7, the first reflection layer 3 is formed on the first semiconductor layer 4. The first reflection layer 3 is laminated on the substrate 2 in advance. That is, the plurality of AlGaAs layers 31 and the plurality of GaAs layers 32 are laminated and formed on the substrate 2. For bonding, the normal temperature bonding method, the atomic diffusion bonding method, or the like is used, as described above.

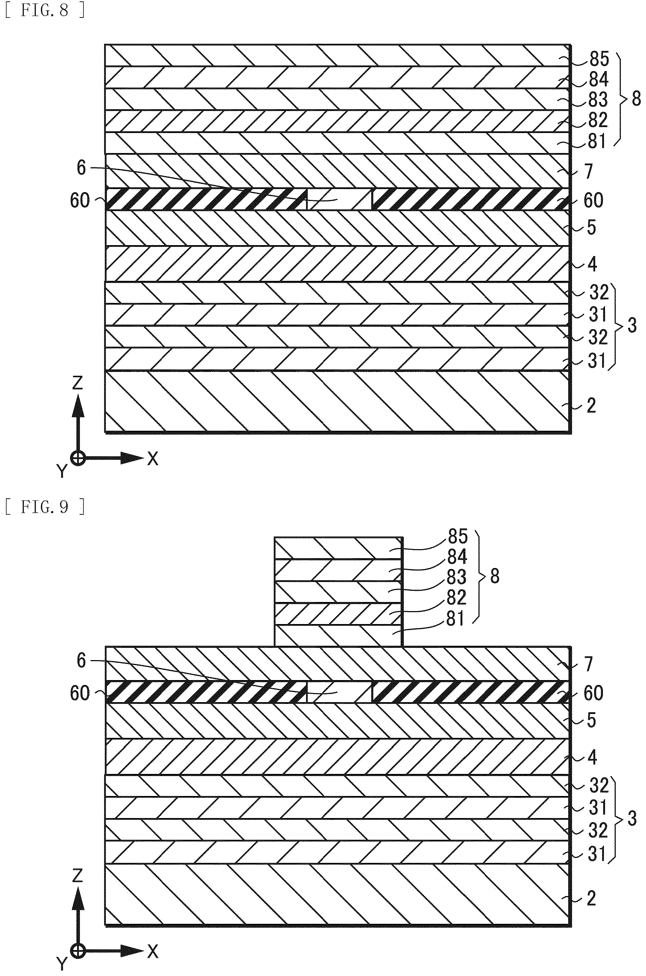

As illustrated in FIG. 8, the substrate 22 is polished, and in addition, the substrate 22 and the etching stop layer 23 are removed using wet etching. As a result, a surface of the second reflection layer 8 is planarized.

As illustrated in FIG. 9, the second reflection layer 8 is formed in a mesa shape. When the mesa shape is formed, a surface of the AlAs layer 82 of the second reflection layer 8 is exposed from a side surface of the mesa shape.

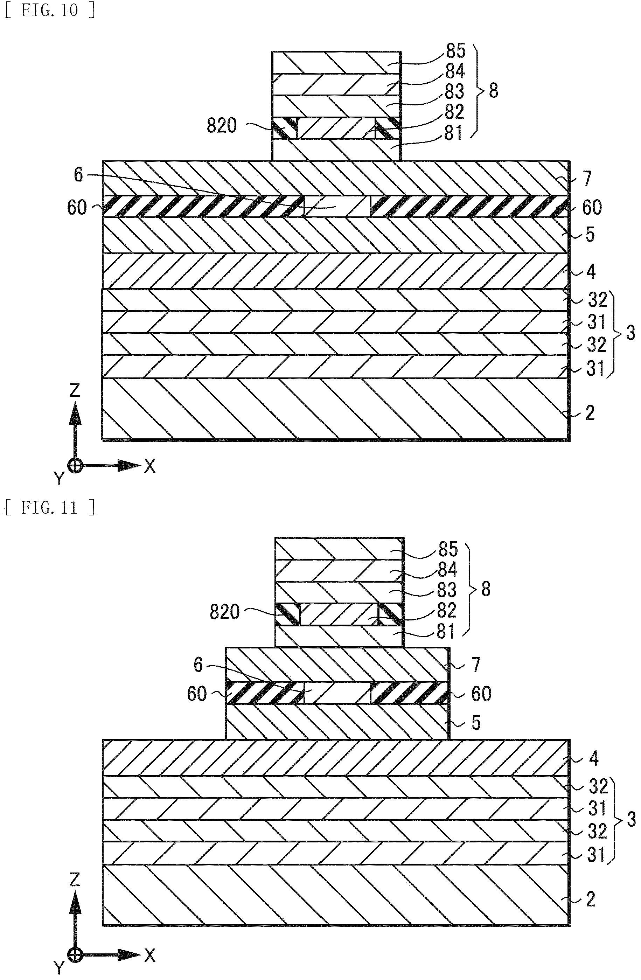

As illustrated in FIG. 10, the light constriction region 820 is formed in a portion of the second reflection layer 8. It is possible to perform selective oxidization of the AlAs layer 82, with respect to the GaAs layer 81, the GaAs layer 83, the AlGaAs layer 84, and the GaAs layer 85. That is, by selectively oxidizing the AlAs layer 82, the AlAs layer 82 in a planar direction from the side surface of the mesa shape to the inside, and the light constriction region 820 is formed. Because the light constriction region 820 is oxidized using H₂O, the light constriction region 820 includes AlOₓ.

As illustrated in FIG. 11, the light emission layer 5, the tunnel junction layer 6 (current constriction region 60), and the second semiconductor layer 7 on the first semiconductor layer 4 are formed in a mesa shape.

Thereafter, as illustrated in FIGs. 1 and 2 above, the first electrode 11 is formed on the first semiconductor layer 4, and the second electrode 12 is formed on the second semiconductor layer 7.

When the series of processes ends, the method for manufacturing the surface emitting device 1 according to the first embodiment is completed, and the surface emitting device 1 is manufactured.

### [Workings and Effect]

The surface emitting device 1 according to the first embodiment includes the second semiconductor layer 7 and the second reflection layer 8, as illustrated in FIGs. 1 and 2. The second semiconductor layer 7 includes the first crystal material. The second reflection layer 8 is formed on the second semiconductor layer 7 and includes the second crystal material of which the lattice constant, the crystal structure, or both are different from the first crystal material. The second reflection layer 8 has a mesa shape.

Here, the light constriction region 820 is formed in a portion of the second reflection layer 8. The light constriction region 820 controls the optical confinement.

Therefore, because the optical confinement is controlled by the light constriction region 820 in the second reflection layer 8, it is possible to construct the current constriction region 60 independently from the light constriction region 820. Therefore, it is possible to implement the surface emitting device 1 that enables to lower the voltage and achieve the optical confinement.

Furthermore, in the surface emitting device 1, as illustrated in FIGs. 1 and 2, the light constriction region 820 is formed by a region oxidized inward from the side surface of the mesa shape. As a result, it is possible to easily form the light constriction region 820.

Moreover, in the surface emitting device 1, as illustrated in FIGs. 1 and 2, the first semiconductor layer 4 and the second semiconductor layer 7 include InP that is the first crystal material. InP is used as the luminescence material in the 1.31 µm band and the 1.55 µm band that are the low loss bands of the optical fiber. Therefore, it is possible to implement the surface emitting device 1 suitable for the optical communication laser device.

Furthermore, in the surface emitting device 1, as illustrated in FIGs. 1 and 2, the second reflection layer 8 is formed by laminating GaAs and AlGaAs that are the second crystal materials. Therefore, because the second reflection layer 8 includes the AlGaAs/GaAs DBR, the second reflection layer 8 has excellent heat dissipation.

Moreover, in the surface emitting device 1, as illustrated in FIGs. 1 and 2, the light constriction region 820 is formed by oxidizing a portion of AlAs that is inserted into a portion of the second reflection layer 8. Therefore, it is possible to easily form the light constriction region 820.

Furthermore, in the surface emitting device 1, as illustrated in FIGs. 1 and 2, the tunnel junction layer 6 is formed between the light emission layer 5 and the second semiconductor layer. Then, the current constriction region 60 is formed around the tunnel junction layer 6. It is possible to optimize the current constriction region 60 independently from the light constriction region 820.

Moreover, in the surface emitting device 1, as illustrated in FIGs. 1 and 2, the first electrode 11 is formed on the first semiconductor layer 4, and the second electrode 12 is formed on the second semiconductor layer 7. That is, it is possible to receive currents from the first semiconductor layer 4 and the second semiconductor layer 7 that are on both of the upper and lower sides of the light emission layer 5 provided therebetween.

Therefore, a current does not flow in a bonded interface between the first reflection layer 3 and the first semiconductor layer 4 and a bonded interface between the second semiconductor layer 7 and the second reflection layer 8, that is, a bonded interface between InP and GaAs. Therefore, because it is possible to effectively suppress or prevent concentration of a current density at the bonded interface, it is possible to prevent the bonded interface from being damaged and broken.

Furthermore, in the surface emitting device 1, as illustrated in FIGs. 1 and 2, the light constriction region 820 is formed at the position separated from the light emission layer 5 by one cycle of the second reflection layer 8 or more. Because the light constriction region 820 is formed by oxidization, a crystal structure is distorted. Because the light emission layer 5 is sufficiently separated from the distortion of the crystal structure, it is possible to effectively suppress or prevent an effect on a light emission operation of the light emission layer 5.

Moreover, in the method for manufacturing the surface emitting device 1 according to the first embodiment, first, as illustrated in FIG. 3, the second semiconductor layer 7 includes the first crystal material.

Next, as illustrated in FIG. 5, the second reflection layer 8 including the second crystal material of which the lattice constant or the crystal structure is different from the first crystal material is formed on the second semiconductor layer 7.

Next, as illustrated in FIG. 9, the second reflection layer 8 is formed in a mesa shape. Then, as illustrated in FIG. 10, the light constriction region 820 that controls the optical confinement is formed in a portion of the second reflection layer 8.

Therefore, in the method for manufacturing the surface emitting device 1, because the light constriction region 820 is formed in a portion of the second reflection layer 8 after the second reflection layer 8 has been formed in the mesa shape, it is possible to easily form the light constriction region 820.

Furthermore, in the method for manufacturing the surface emitting device 1, as illustrated in FIG. 10, the light constriction region 820 is formed by oxidizing a portion of the second reflection layer 8 inward from the side surface of the mesa shape of the second reflection layer 8. Here, the second reflection layer 8 is formed by laminating GaAs and AlGaAs that are the second crystal materials. The light constriction region 820 is formed by oxidizing a portion of AlAs that is inserted between GaAs and AlGaAs of the second reflection layer 8 exposed from the side surface of the mesa shape.

Therefore, because the light constriction region 820 is formed by selective oxidization, it is not necessary to form an oxidization mask, and it is possible to reduce the number of manufacturing processes in the method for manufacturing the surface emitting device 1.

In addition, because the number of manufacturing processes is reduced, it is possible to improve a manufacturing yield.

### <2. Second Embodiment>

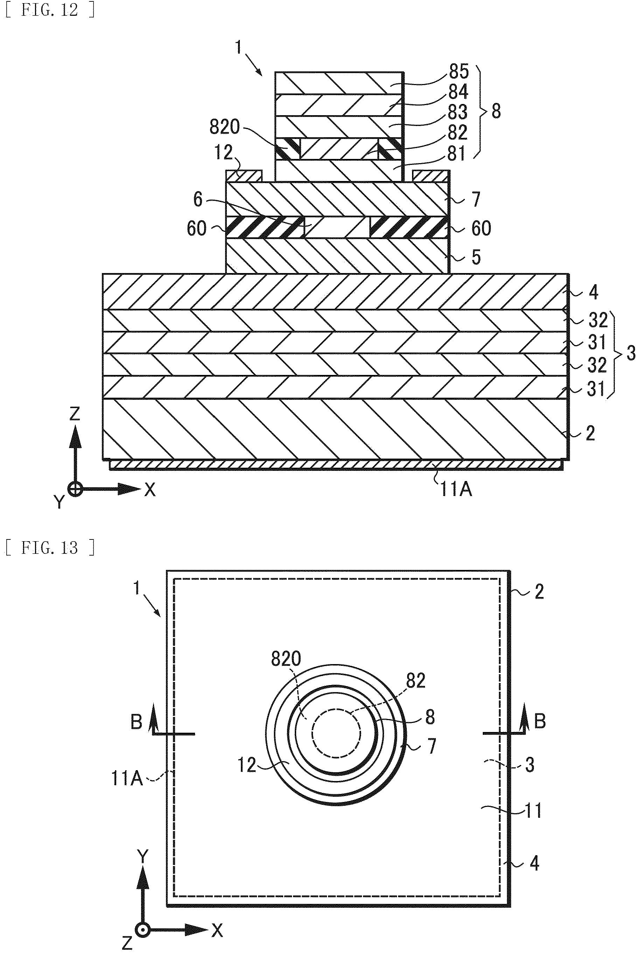

A surface emitting device 1 according to a second embodiment of the present disclosure is described with reference to FIGs. 12 and 13.

Note that in the second and subsequent embodiments, components that are the same as or substantially the same as the components of the surface emitting device 1 according to the first embodiment and the method for manufacturing the surface emitting device 1 are denoted with the same reference numerals, and overlapped description is omitted.

### [Configuration of Surface Emitting Device 1]

FIG. 12 illustrates an example of a longitudinal cross section configuration of the surface emitting device 1 according to the second embodiment. Furthermore, FIG. 13 illustrates an example of a plane configuration of the surface emitting device 1.

In the surface emitting device 1 according to the second embodiment, a first electrode 11A is formed, instead of the first electrode 11 of the surface emitting device 1 according to the first embodiment. The first electrode 11A is formed under a first reflection layer 3. More specifically, the first electrode 11A is arranged under the first reflection layer 3 as interposing a substrate 2 therebetween, and the first electrode 11A is formed across a substantially entire region of a rear surface of the substrate 2.

Components other than the above are the same as the components of the surface emitting device 1 according to the first embodiment. Furthermore, formation processes other than a formation process of the first electrode 11A are the same as the respective processes of the method for manufacturing the surface emitting device 1 according to the first embodiment.

According to the surface emitting device 1 according to the second embodiment and the method for manufacturing the surface emitting device 1, it is possible to obtain workings and effects similar to those obtained by the surface emitting device 1 according to the first embodiment and the method for manufacturing the surface emitting device 1.

Furthermore, in the surface emitting device 1 according to the second embodiment, the first electrode 11A is formed under the first reflection layer 3 via the substrate 2 as illustrated in FIGs. 12 and 13. Although a current flows in a bonded interface between a first semiconductor layer 4 and the first reflection layer 3, because a current path from a light emission layer 5 to the first electrode 11A is gradually widened, a current density at the bonded interface does not increase. Therefore, with the surface emitting device 1 and the manufacturing method thereof, it is possible to easily form the first electrode 11A. In particular, a structure that is advantageous for the low-output surface emitting device 1 is achieved.

### <3. Third Embodiment>

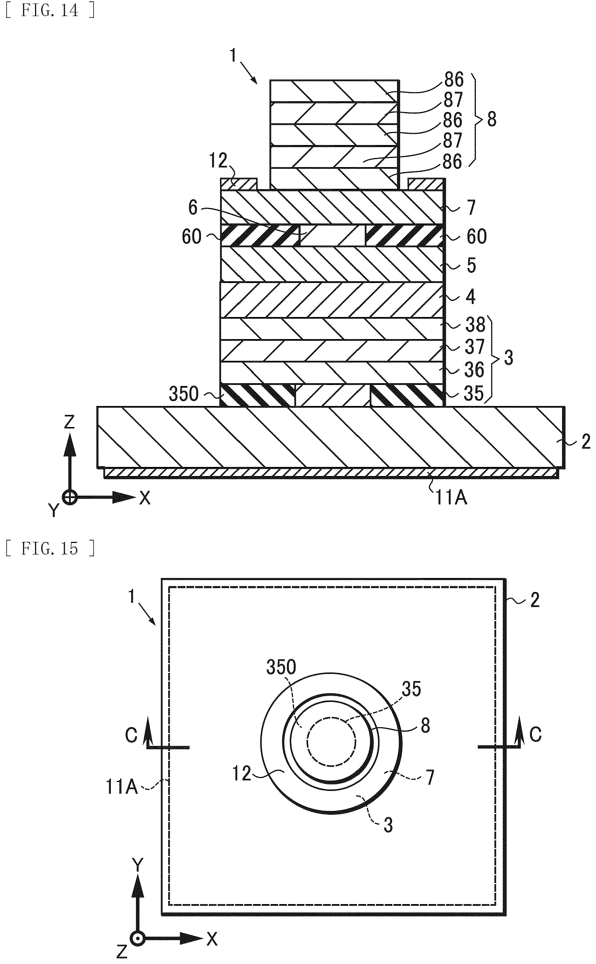

A surface emitting device 1 according to a third embodiment of the present disclosure is described with reference to FIGs. 14 and 15.

### [Configuration of Surface Emitting Device 1]

FIG. 14 illustrates an example of a longitudinal cross section configuration of the surface emitting device 1 according to the third embodiment. Furthermore, FIG. 15 illustrates an example of a plane configuration of the surface emitting device 1.

In the surface emitting device 1 according to the third embodiment, the configuration of each of the first reflection layer 3 and the second reflection layer 8 of the surface emitting device 1 according to the second embodiment is changed.

More specifically, the first reflection layer 3 is formed by laminating an n-type AlAs layer 35, an n-type GaAs layer 36, an n-type AlGaAs layer 37, and an n-type GaAs layer 38 in order. The first reflection layer 3 is formed in a mesa shape.

Then, a light constriction region 350 is formed by oxidizing a portion of the first reflection layer 3. Similarly to the light constriction region 820 of the surface emitting device 1 according to the first embodiment, the light constriction region 350 is formed by selectively oxidizing the AlAs layer 35 inward from a side surface of the mesa shape.

The second reflection layer 8 is formed by repeatedly laminating a plurality of GaAs layers 86 and a plurality of AlGaAs layers 87, similarly to the first reflection layer 3 of the surface emitting device 1 according to the first embodiment. That is, the second reflection layer 8 is formed as a semiconductor DBR.

Components other than the above are the same as the components of the surface emitting device 1 according to the second embodiment. Furthermore, although components of the first reflection layer 3 and the second reflection layer 8 are different, a method for manufacturing the surface emitting device 1 according to the third embodiment is substantially the same as the method for manufacturing the surface emitting device 1 according to the first embodiment.

According to the surface emitting device 1 according to the third embodiment and the method for manufacturing the surface emitting device 1, it is possible to obtain workings and effects similar to those obtained by the surface emitting device 1 according to the second embodiment and the method for manufacturing the surface emitting device 1.

Furthermore, in the surface emitting device 1 according to the third embodiment, as illustrated in FIGs. 14 and 15, current constriction is controlled in a current constriction region 60, and a bonded interface between a first semiconductor layer 4 and the first reflection layer 3 is formed at a position separated from a light emission layer 5. Therefore, it is possible to lower a current density at the bonded interface.

Note that, in the third embodiment, the light constriction region 350 may have a configuration that controls current constriction. Furthermore, in the third embodiment, the first reflection layer 3 includes the light constriction region 350, and the light constriction region 820 may be formed in the second reflection layer 8, similarly to the second reflection layer 8 of the surface emitting device 1 according to the first embodiment or the second embodiment.

### <4. Fourth Embodiment>

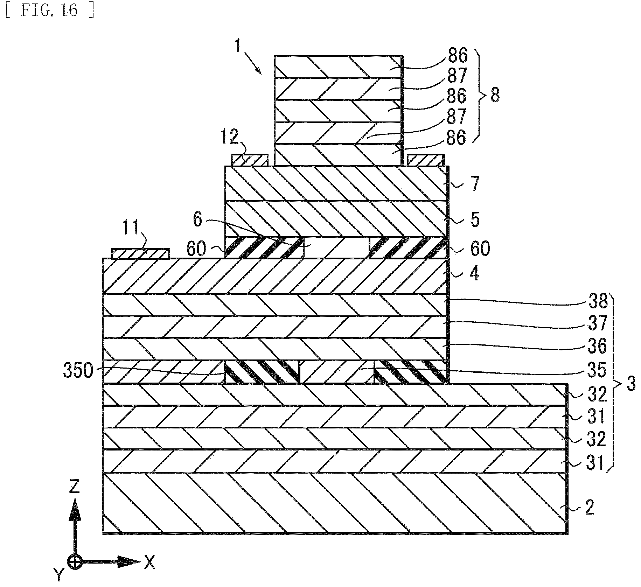

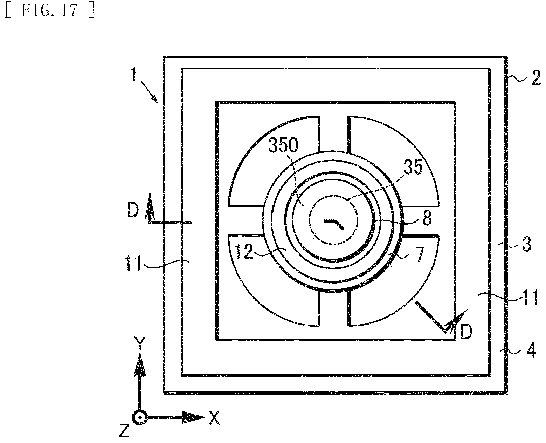

A surface emitting device 1 according to a fourth embodiment of the present disclosure is described with reference to FIGs. 16 and 17.

### [Configuration of Surface Emitting Device 1]

FIG. 16 illustrates an example of a longitudinal cross section configuration of the surface emitting device 1 according to the fourth embodiment. Furthermore, FIG. 17 illustrates an example of a plane configuration of the surface emitting device 1.

In the surface emitting device 1 according to the fourth embodiment, the configurations of the first reflection layer 3 and the first electrode 11A of the surface emitting device 1 according to the third embodiment are changed.

In the surface emitting device 1 according to the third embodiment, the first reflection layer 3 is formed on a substrate 2. The first reflection layer 3 is formed by repeatedly laminating a plurality of AlGaAs layers 31 and a plurality of GaAs layers 32 similarly to the first reflection layer 3 of the surface emitting device 1 according to the first embodiment and further laminating an AlAs layer 35, a GaAs layer 36, an AlGaAs layer 37, and a GaAs layer 38 in order similarly to the first reflection layer 3 according to the third embodiment.

A portion of the first semiconductor layer 4 and a portion from the GaAs layer 38 to the AlAs layer 35 of the first reflection layer 3 are formed in a mesa shape. As illustrated in FIG. 17, a portion of the first semiconductor layer 4 on a 45-degree upper side and a 135-degree upper side in planar view and a portion of the first reflection layer 3 are sectorally removed and is formed in a mesa shape.

A light constriction region 350 is formed by a region obtained by oxidizing a portion of the AlAs layer 35 inward from a side surface of the mesa shape.

Furthermore, in the fourth embodiment, a tunnel junction layer 6 and a current constriction region 60 are formed between the first semiconductor layer 4 and a light emission layer 5.

A first electrode 11 is formed on a surface of the first semiconductor layer 4 that is not formed in a mesa shape. That is, the first electrode 11 is formed to have an intra-cavity structure.

Components other than the above are the same as the components of the surface emitting device 1 according to the third embodiment. Furthermore, although components of the first reflection layer 3 are different, a method for manufacturing the surface emitting device 1 according to the fourth embodiment is substantially the same as the method for manufacturing the surface emitting device 1 according to the first embodiment.

According to the surface emitting device 1 according to the fourth embodiment and the method for manufacturing the surface emitting device 1, it is possible to obtain workings and effects similar to those obtained by the surface emitting device 1 according to the third embodiment and the method for manufacturing the surface emitting device 1.

Furthermore, in the surface emitting device 1 according to the fourth embodiment, as illustrated in FIGs. 16 and 17, it is sufficient that a portion of the first reflection layer 3 be formed in the mesa shape. If a surface of the AlAs layer 35 of the first reflection layer 3 is exposed from a side surface of a portion of the mesa shape, it is possible to progress oxidization, and it is possible to form the light constriction region 350.

Moreover, in the surface emitting device 1, as illustrated in FIGs. 16 and 17, the first electrode 11 is formed to have the intra-cavity structure. Therefore, a current does not flow in a bonded interface between the first reflection layer 3 and the first semiconductor layer 4. Therefore, because it is possible to effectively suppress or prevent concentration of a current density at the bonded interface, it is possible to prevent the bonded interface from being damaged and broken.

### <5. Fifth Embodiment>

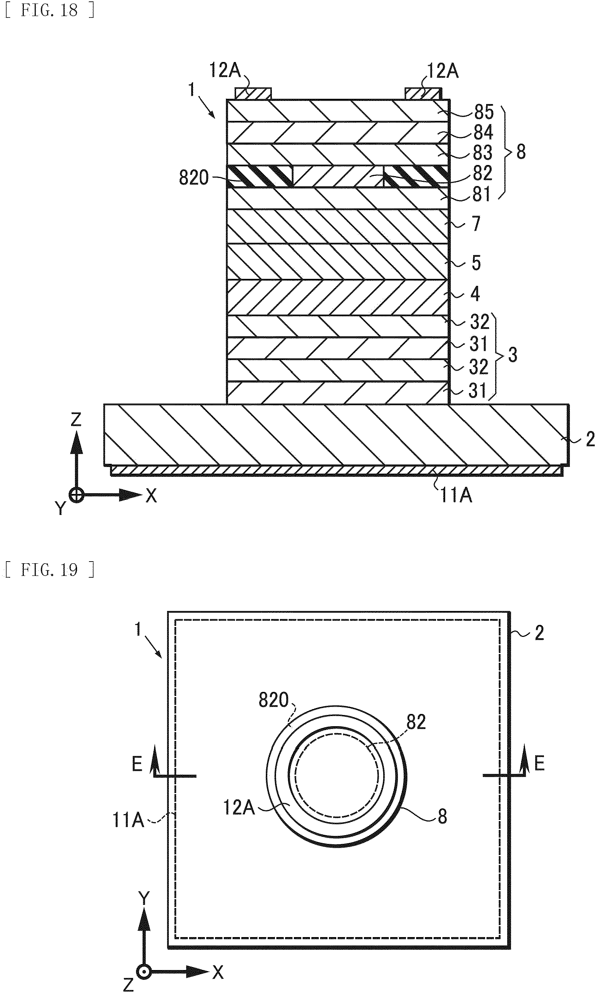

A surface emitting device 1 according to a fifth embodiment of the present disclosure is described with reference to FIGs. 18 and 19.

### [Configuration of Surface Emitting Device 1]

FIG. 18 illustrates an example of a longitudinal cross section configuration of a surface emitting device 1 according to a fifth embodiment. Furthermore, FIG. 19 illustrates an example of a plane configuration of the surface emitting device 1.

In the surface emitting device 1 according to the fifth embodiment, a first semiconductor layer 4 includes n-type InP, a light emission layer 5 includes an undoped **InP** material, and in addition, a second semiconductor layer 7 includes p-type InP. That is, the surface emitting device 1 has a pn junction structure that does not include the tunnel junction layer 6 and the current constriction region 60 of the surface emitting device 1 according to the first embodiment.

The second reflection layer 8 partially includes a light constriction region 820, similarly to the second reflection layer 8 of the surface emitting device 1 according to the first embodiment. In the fifth embodiment, the light constriction region 820 is also used as a current constriction region.

Furthermore, in the fifth embodiment, the first reflection layer 3, the first semiconductor layer 4, the light emission layer 5, the second semiconductor layer 7, and the second reflection layer 8 are formed in mesa shapes having the same size. Note that the mesa shapes of the first reflection layer 3, the first semiconductor layer 4, the light emission layer 5, the second semiconductor layer 7, and the second reflection layer 8 may be different.

A first electrode 11A is formed across a substantially entire region of a rear surface of a substrate 2, similarly to the first electrode 11A of the surface emitting device 1 according to the second embodiment.

A second electrode 12A is formed on the second reflection layer 8. Specifically, the second electrode 12A is formed on a GaAs layer 85 of the second reflection layer 8. The second electrode 12A is formed in a ring shape in planar view.

Components other than the above are the same as the components of the surface emitting device 1 according to the second embodiment. Furthermore, a method for manufacturing the surface emitting device 1 according to the fifth embodiment is substantially the same as the method for manufacturing the surface emitting device 1 according to the second embodiment.

According to the surface emitting device 1 according to the fifth embodiment and the method for manufacturing the surface emitting device 1, it is possible to obtain workings and effects similar to those obtained by the surface emitting device 1 according to the second embodiment and the method for manufacturing the surface emitting device 1.

Furthermore, in the surface emitting device 1 according to the fifth embodiment, the light constriction region 820 is formed in a portion of the second reflection layer 8. This light constriction region 820 also serves as a current constriction region. For the light constriction region 820, AlOₓ is used that is obtained by oxidizing an AlAs layer 82 having results of current control and optical confinement control. Therefore, it is possible to use the light constriction region 820 as the current constriction region. In particular, in the surface emitting device 1 with a constant-current and low-voltage specification, because a current density at a bonded interface is small, effective use is possible without damaging and breaking the bonded interface.

### <6. Sixth Embodiment>

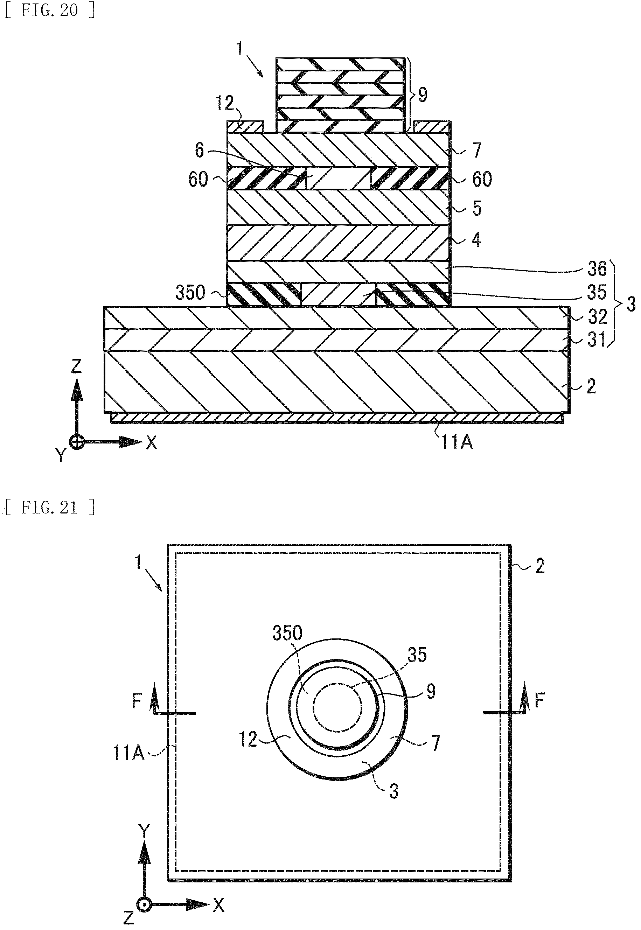

A surface emitting device 1 according to a sixth embodiment of the present disclosure is described with reference to FIGs. 20 and 21.

### [Configuration of Surface Emitting Device 1]

FIG. 20 illustrates an example of a longitudinal cross section configuration of the surface emitting device 1 according to the sixth embodiment. Furthermore, FIG. 21 illustrates an example of a plane configuration of the surface emitting device 1.

In the surface emitting device 1 according to the sixth embodiment, a second reflection layer 9 is formed, instead of the second reflection layer 8 of the surface emitting device 1 according to the third embodiment. The second reflection layer 9 is a dielectric body DBR formed by repeatedly laminating dielectric bodies having different refractive indexes. As the dielectric body, for example, it is possible to use SiO₂, SiN, or the like.

Components other than the above are the same as the components of the surface emitting device 1 according to the third embodiment. Furthermore, a method for manufacturing the surface emitting device 1 according to the sixth embodiment is substantially the same as the method for manufacturing the surface emitting device 1 according to the third embodiment.

According to the surface emitting device 1 according to the sixth embodiment and the method for manufacturing the surface emitting device 1, it is possible to obtain workings and effects similar to those obtained by the surface emitting device 1 according to the third embodiment and the method for manufacturing the surface emitting device 1.

Furthermore, in the surface emitting device 1 according to the sixth embodiment, as illustrated in FIGs. 20 and 21, a light constriction region 350 is formed in a portion of a first reflection layer 3 on a side of a substrate 2. Therefore, by bonding the substrate 2 to a first semiconductor layer 4, it is possible to easily form the first reflection layer 3 and the light constriction region 350.

### <7. Seventh Embodiment>

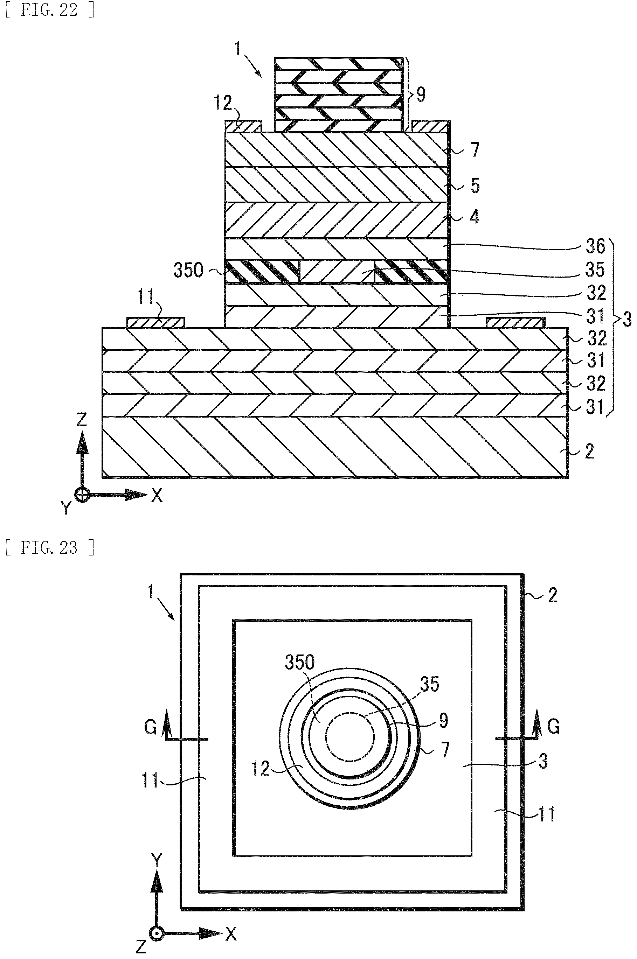

A surface emitting device 1 according to a seventh embodiment of the present disclosure is described with reference to FIGs. 22 and 23.

### [Configuration of Surface Emitting Device 1]

FIG. 22 illustrates an example of a longitudinal cross section configuration of the surface emitting device 1 according to the seventh embodiment. Furthermore, FIG. 23 illustrates an example of a plane configuration of the surface emitting device 1.

The surface emitting device 1 according to the seventh embodiment is an application example in which the surface emitting device 1 according to the fifth embodiment and the surface emitting device 1 according to the sixth embodiment are combined.

In the surface emitting device 1 according to the seventh embodiment, a first reflection layer 3 is formed on a substrate 2. The first reflection layer 3 is formed by repeatedly laminating a plurality of p-type AlGaAs layers 31 and a plurality of p-type GaAs layers 32 and further laminating a p-type AlAs layer 35 and a p-type GaAs layer 36 in order, similarly to the first reflection layer 3 of the surface emitting device 1 according to the first embodiment. A portion of the AlGaAs layer 31 and the GaAs layer 32, the AlAs layer 35, and the GaAs layer 36 are formed in a mesa shape.

A light constriction region 350 is formed by a region obtained by oxidizing a portion of the AlAs layer 35 inward from a side surface of the mesa shape.

Here, a first semiconductor layer 4 includes p-type InP, a light emission layer 5 includes an undoped InP material, and a second semiconductor layer 7 includes n-type InP. That is, the tunnel junction layer 6 and the current constriction region 60 of the surface emitting device 1 according to the first embodiment are not formed, the surface emitting device 1 has a pn junction structure.

Furthermore, a second reflection layer 9 is a dielectric body DBR. Furthermore, a first electrode 11 is formed on the GaAs 32 of the first reflection layer 3. A second electrode 12 is formed on the second semiconductor layer 7.

Note that the first electrode 11 may be replaced with a first electrode 11A. For example, as illustrated in FIG. 18, the first electrode 11A is formed across a substantially entire region of a rear surface of the substrate 2.

Components other than the above are the same as the components of the surface emitting device 1 according to the fifth embodiment or the sixth embodiment. Furthermore, a method for manufacturing the surface emitting device 1 according to the seventh embodiment is substantially the same as the method for manufacturing the surface emitting device 1 according to the fifth embodiment or the sixth embodiment.

According to the surface emitting device 1 according to the seventh embodiment and the method for manufacturing the surface emitting device 1, it is possible to obtain workings and effects similar to those obtained by the surface emitting device 1 according to the sixth embodiment and the method for manufacturing the surface emitting device 1.

### <8. Eighth Embodiment>

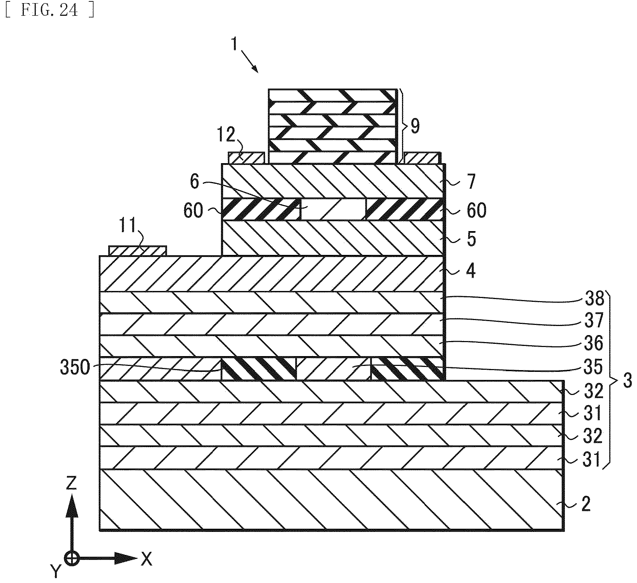

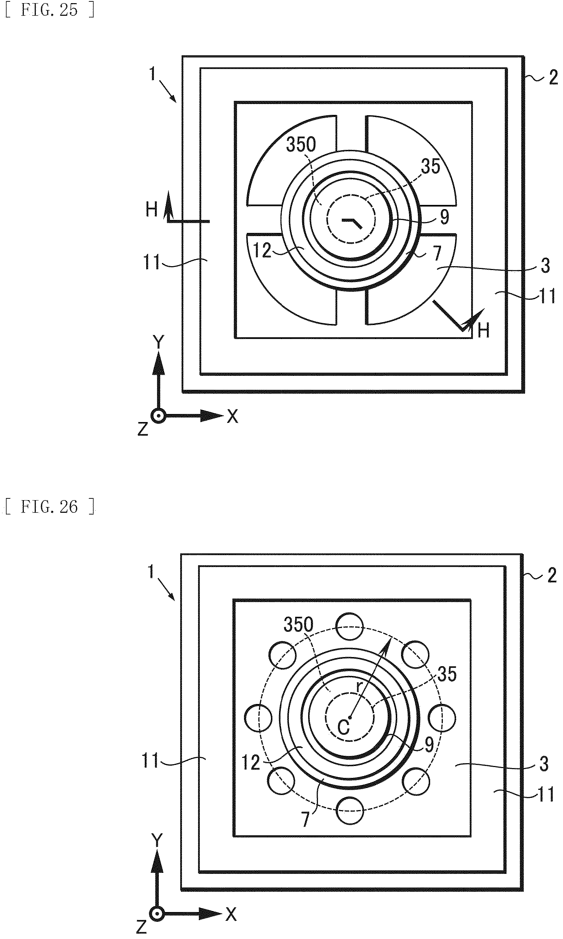

A surface emitting device 1 according to an eighth embodiment of the present disclosure is described with reference to FIGs. 24 and 25.

### [Configuration of Surface Emitting Device 1]

FIG. 24 illustrates an example of a longitudinal cross section configuration of the surface emitting device 1 according to the eighth embodiment. Furthermore, FIG. 25 illustrates an example of a plane configuration of the surface emitting device 1.

The surface emitting device 1 according to the eighth embodiment is an application example in which the surface emitting device 1 according to the fourth embodiment and the surface emitting device 1 according to the sixth embodiment are combined.

In the surface emitting device 1 according to the eighth embodiment, a second reflection layer 9 is formed instead of the second reflection layer 8, in the surface emitting device 1 according to the fourth embodiment.

Furthermore, in the eighth embodiment, a tunnel junction layer 6 and a current constriction region 60 are formed between a light emission layer 5 and a second semiconductor layer 7.

Components other than the above are the same as the components of the surface emitting device 1 according to the fourth embodiment or the sixth embodiment. Furthermore, a method for manufacturing the surface emitting device 1 according to the eighth embodiment is substantially the same as the method for manufacturing the surface emitting device 1 according to the fourth embodiment or the sixth embodiment.

According to the surface emitting device 1 according to the eighth embodiment and the method for manufacturing the surface emitting device 1, it is possible to obtain workings and effects similar to those obtained by the surface emitting device 1 according to the fourth embodiment or the sixth embodiment and the method for manufacturing the surface emitting device 1.

### <9. Ninth Embodiment>

A surface emitting device 1 according to a ninth embodiment of the present disclosure is described with reference to FIG. 26.

### [Configuration of Surface Emitting Device 1]

FIG. 26 illustrates an example of a plane configuration of the surface emitting device 1 according to the ninth embodiment.

The surface emitting device 1 according to the ninth embodiment is an application example of the surface emitting device 1 according to the eighth embodiment.

In the surface emitting device 1 according to the ninth embodiment, a mesa shape of a portion of a first reflection layer 3, a first semiconductor layer 4, a light emission layer 5, a tunnel junction layer 6 (current constriction region 60), and a second semiconductor layer 7 in the surface emitting device 1 according to the eighth embodiment is formed in a dotted pattern.

More specifically, in planar view, dots (lock hole. Reference numeral is omitted) arranged at constant intervals, on a circle (broken line), illustrated for convenience, drawn at a position separated from a center C of the mesa shape by a radius r form the mesa shape. The dot is formed at a depth reaching an AlAs layer 35 of the first reflection layer 3. A light constriction region 350 is formed by a region oxidized through the dot.

Note that a planar shape of the dot is not limited to a circular shape and may be a shape such as an elliptical shape or a rectangular shape.

Components other than the above are the same as the components of the surface emitting device 1 according to the eighth embodiment. Furthermore, a method for manufacturing the surface emitting device 1 according to the ninth embodiment is substantially the same as the method for manufacturing the surface emitting device 1 according to the eighth embodiment.

According to the surface emitting device 1 according to the ninth embodiment and the method for manufacturing the surface emitting device 1, it is possible to obtain workings and effects similar to those obtained by the surface emitting device 1 according to the eighth embodiment and the method for manufacturing the surface emitting device 1.

### <10. Tenth Embodiment>

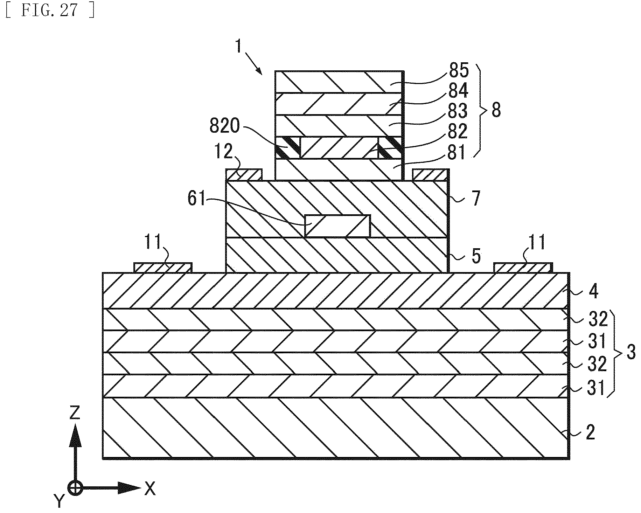

A surface emitting device 1 according to a tenth embodiment of the present disclosure is described with reference to FIG. 27.

### [Configuration of Surface Emitting Device 1]

FIG. 27 illustrates an example of a longitudinal cross section configuration of the surface emitting device 1 according to the tenth embodiment.

The surface emitting device 1 according to the tenth embodiment is an application example of the surface emitting device 1 according to the first embodiment.

In the surface emitting device 1 according to the tenth embodiment, the tunnel junction layer 6 of the surface emitting device 1 according to the first embodiment is replaced with a buried tunnel junction layer 61.

Components other than the above are the same as the components of the surface emitting device 1 according to the first embodiment. Furthermore, a method for manufacturing the surface emitting device 1 according to the tenth embodiment is substantially the same as the method for manufacturing the surface emitting device 1 according to the first embodiment.

According to the surface emitting device 1 according to the tenth embodiment and the method for manufacturing the surface emitting device 1, it is possible to obtain workings and effects similar to those obtained by the surface emitting device 1 according to the first embodiment and the method for manufacturing the surface emitting device 1.

### <11. Other Embodiments>

The present technology is not limited to the above embodiments, and it is possible to make various modifications. The scope of the protection is defined by the independent claims.

For example, in the present technology, it is possible to combine two or more of the surface emitting devices according to the plurality of embodiments.

A surface emitting device according to a first mode of the present disclosure includes a semiconductor layer and a reflection layer. The semiconductor layer includes a first crystal material. The reflection layer is formed on the semiconductor layer and includes a second crystal material of which at least a lattice constant or a crystal structure is different from the first crystal material. The reflection layer has a mesa shape.

Here, a light constriction region is formed in a portion of the reflection layer. In the light constriction region, optical confinement is controlled.

Therefore, because the optical confinement is controlled by the light constriction region in the reflection layer, it is possible to construct a current constriction region independently from the light constriction region. Therefore, it is possible to implement the surface emitting device that enables to lower a voltage and achieve the optical confinement.

A surface emitting device according to a second mode of the present disclosure includes a first reflection layer, a first semiconductor layer, a light emission layer, a second semiconductor layer, and a second reflection layer laminated in order. The first semiconductor layer, the second semiconductor layer, or both include a first crystal material. The first reflection layer, the second reflection layer, or both include a second crystal material of which a lattice constant or a crystal structure is different from the first crystal material and further has a mesa shape.

Here, in a portion of the first reflection layer, the second reflection layer, or both, a light constriction region that controls optical confinement is further included. In the light constriction region, the optical confinement is controlled.

Therefore, because it is possible to control the optical confinement by the light constriction region in the first reflection layer, the second reflection layer, or both, it is possible to construct a current constriction region independently from the light constriction region. Therefore, it is possible to implement the surface emitting device that enables to lower a voltage and achieve the optical confinement.

A method for manufacturing a surface emitting device according to a third mode of the present disclosure forms a semiconductor layer with a first crystal material, forms a reflection layer on the semiconductor layer with a second crystal material of which a lattice constant or a crystal structure is different from the first crystal material, forms the reflection layer in a mesa shape, and forms a light constriction region that controls optical confinement in a portion of the reflection layer.

Therefore, with the method for manufacturing the surface emitting device 1, because the light constriction region is formed in a portion of the reflection layer after the reflection layer is formed in the mesa shape, it is possible to easily form the light constriction region.

The present application claims the benefit of Japanese Priority Patent Application No. 2021-138210 filed with Japan Patent Office on August 26, 2021.

It should be understood by those skilled in the art that various modifications, combinations, sub-combinations and alterations may occur depending on design requirements and other factors insofar as they are within the scope of the appended claims

## Claims

1. A surface emitting device (1) comprising:
a first reflection layer (3), a first semiconductor layer (4), a light emission layer (5), a second semiconductor layer (7), and a second reflection layer (8) laminated in order; and
a light constriction region (820), wherein
the first semiconductor layer, the second semiconductor layer, or both include a first crystal material,
the first reflection layer, the second reflection layer, or both include a second crystal material of which a lattice constant or a crystal structure is different from the first crystal material and further has a mesa shape,
the light constriction region controls optical confinement in a portion of the first reflection layer, the second reflection layer, or both;
**characterized by**
a tunnel junction layer (6) formed between the first semiconductor layer and the light emission layer or between the light emission layer and the second semiconductor layer; and
a current constriction region (60) formed around the tunnel junction layer.

2. The surface emitting device according to claim 1, further comprising:
a first electrode formed on the first semiconductor layer; and
a second electrode formed on the second semiconductor layer.

3. The surface emitting device according to claim 1, further comprising:
a first electrode formed on the first reflection layer; and
a second electrode formed on the second semiconductor layer.

4. The surface emitting device according to claim 1, further comprising:
a first electrode formed on the first semiconductor layer or the first reflection layer; and
a second electrode formed on the second reflection layer.

5. The surface emitting device according to claim 1, wherein the light constriction region includes a region that is oxidized inward from a side surface of the mesa shape.

6. The surface emitting device according to claim 1, wherein the first reflection layer or the second reflection layer includes GaAs and AlGaAs that are the second crystal materials, the GaAs and the AlGaAs being laminated on each other.

7. The surface emitting device according to claim 6, wherein the light constriction region is formed by oxidizing a portion of AlAs that is inserted between the GaAs and the AlGaAs.

8. The surface emitting device according to claim 6, wherein the light constriction region is formed at a position separated from the light emission layer by one cycle of the first reflection layer or the second reflection layer or more.

9. A method for manufacturing a surface emitting device comprising:
forming a first reflection layer (3);
forming a first semiconductor layer (4);
forming a light emission layer (5);
forming a second semiconductor layer (7);
forming a second reflection layer (8) on the semiconductor layer; wherein
the first semiconductor layer, the second semiconductor layer, or both include a first crystal material;
the first reflection layer, the second reflection layer, or both include a second crystal material of which a lattice constant or a crystal structure is different from the first crystal material and further has a mesa shape; and
the method comprises:
forming a light constriction region (820) that controls optical confinement in a portion of the first reflection layer, second reflection layer or both;
**characterized by**
forming a tunnel junction layer (6) between the first semiconductor layer and the light emission layer or between the light emission layer and the second semiconductor layer ; and
forming a current constriction region (60) around the tunnel junction layer.

10. The method for manufacturing the surface emitting device according to claim 9,
wherein
the first reflection layer, second reflection layer or both include GaAs and AlGaAs that are the second crystal materials, the GaAs and the AlGaAs being laminated on each other,
and
the light constriction region is formed by oxidizing a portion of AlAs, inserted between the GaAs and the AlGaAs, exposed from a side surface of the mesa shape.

## Patentansprüche

1. Oberflächenemittierende Vorrichtung (1), umfassend:
eine erste Reflexionsschicht (3), eine erste Halbleiterschicht (4), eine Lichtemissionsschicht (5), eine zweite Halbleiterschicht (7) und eine zweite Reflexionsschicht (8), die der Reihe nach laminiert sind; und
einen Lichtverengungsbereich (820), wobei
die erste Halbleiterschicht, die zweite Halbleiterschicht oder beide ein erstes Kristallmaterial einschließen,
die erste Reflexionsschicht, die zweite Reflexionsschicht oder beide ein zweites Kristallmaterial einschließen, dessen Gitterkonstante oder Kristallstruktur sich von dem ersten Kristallmaterial unterscheidet und ferner eine Mesaform aufweist,
der Lichtverengungsbereich die optische Eingrenzung in einem Abschnitt der ersten Reflexionsschicht, der zweiten Reflexionsschicht oder beider steuert; **gekennzeichnet durch**
eine Tunnelübergangsschicht (6), die zwischen der ersten Halbleiterschicht und der Lichtemissionsschicht oder zwischen der Lichtemissionsschicht und der zweiten Halbleiterschicht gebildet ist; und
einen Stromverengungsbereich (60), der um die Tunnelübergangsschicht herum ausgebildet ist.

2. Oberflächenemittierende Vorrichtung nach Anspruch 1, ferner umfassend:
eine erste Elektrode, die auf der ersten Halbleiterschicht gebildet ist; und
eine zweite Elektrode, die auf der zweiten Halbleiterschicht gebildet ist.

3. Oberflächenemittierende Vorrichtung nach Anspruch 1, ferner umfassend:
eine erste Elektrode, die auf der ersten Reflexionsschicht gebildet ist; und
eine zweite Elektrode, die auf der zweiten Halbleiterschicht gebildet ist.

4. Oberflächenemittierende Vorrichtung nach Anspruch 1, ferner umfassend:
eine erste Elektrode, die auf der ersten Halbleiterschicht oder der ersten Reflexionsschicht gebildet ist; und
eine zweite Elektrode, die auf der zweiten Reflexionsschicht gebildet ist.

5. Oberflächenemittierende Vorrichtung nach Anspruch 1, wobei der Lichtverengungsbereich einen Bereich einschließt, der von einer seitlichen Oberfläche der Mesaform nach innen oxidiert ist.

6. Oberflächenemittierende Vorrichtung nach Anspruch 1, wobei die erste Reflexionsschicht oder die zweite Reflexionsschicht GaAs und AlGaAs einschließt, welche die zweiten Kristallmaterialien sind, wobei das GaAs und das AlGaAs aufeinander laminiert sind.

7. Oberflächenemittierende Vorrichtung nach Anspruch 6, wobei der Lichtverengungsbereich durch Oxidieren eines Abschnitts von AlAs gebildet wird, der zwischen dem GaAs und dem AlGaAs eingefügt ist.

8. Oberflächenemittierende Vorrichtung nach Anspruch 6, wobei der Lichtverengungsbereich an einer Position ausgebildet ist, die von der Lichtemissionsschicht durch einen Zyklus der ersten Reflexionsschicht oder der zweiten Reflexionsschicht oder mehr getrennt ist.

9. Verfahren zum Herstellen einer oberflächenemittierenden Vorrichtung, umfassend:
Bilden einer ersten Reflexionsschicht (3);
Bilden einer ersten Halbleiterschicht (4);
Bilden einer Lichtemissionsschicht (5);
Bilden einer zweiten Halbleiterschicht (7);
Bilden einer zweiten Reflexionsschicht (8) auf der Halbleiterschicht; wobei
die erste Halbleiterschicht, die zweite Halbleiterschicht oder beide ein erstes Kristallmaterial einschließen;
die erste Reflexionsschicht, die zweite Reflexionsschicht oder beide ein zweites Kristallmaterial einschließen, dessen Gitterkonstante oder Kristallstruktur sich von dem ersten Kristallmaterial unterscheidet und ferner eine Mesaform aufweist; und
das Verfahren umfasst:
Bilden eines Lichtverengungsbereichs (820), der die optische Eingrenzung in einem Abschnitt der ersten Reflexionsschicht, der zweiten Reflexionsschicht oder beider steuert; **gekennzeichnet durch**
Bilden einer Tunnelübergangsschicht (6) zwischen der ersten Halbleiterschicht und der Lichtemissionsschicht oder zwischen der Lichtemissionsschicht und der zweiten Halbleiterschicht; und
Bilden eines Stromverengungsbereichs (60) um die Tunnelübergangsschicht herum.

10. Verfahren zum Herstellen der oberflächenemittierenden Vorrichtung nach Anspruch 9, wobei
die erste Reflexionsschicht, die zweite Reflexionsschicht oder beide GaAs und AlGaAs einschließen, welche die zweiten Kristallmaterialien sind, wobei das GaAs und das AlGaAs aufeinander laminiert sind, und
der Lichtverengungsbereich durch Oxidieren eines Abschnitts von AlAs gebildet wird, der zwischen dem GaAs und dem AlGaAs eingefügt ist und von einer seitlichen Oberfläche der Mesaform freiliegt.

## Revendications

1. Dispositif d'émission en surface (1) comprenant :
une première couche de réflexion (3), une première couche semi-conductrice (4), une couche d'émission de lumière (5), une seconde couche semi-conductrice (7) et une seconde couche de réflexion (8) stratifiées dans l'ordre ; et
une région de constriction de lumière (820), dans lequel
la première couche semi-conductrice, la seconde couche semi-conductrice ou les deux comportent un premier matériau cristallin,
la première couche de réflexion, la seconde couche de réflexion ou les deux comportent un second matériau cristallin dont une constante de réseau ou une structure cristalline est différente de celle du premier matériau cristallin et qui présente en outre une forme en mésa,
la région de constriction de lumière commande le confinement optique dans une partie de la première couche de réflexion, de la seconde couche de réflexion ou des deux ; **caractérisé par**
une couche de jonction tunnel (6) formée entre la première couche semi-conductrice et la couche d'émission de lumière ou entre la couche d'émission de lumière et la seconde couche semi-conductrice ; et
une région de constriction de courant (60) formée autour de la couche de jonction tunnel.

2. Dispositif d'émission en surface selon la revendication 1, comprenant en outre :
une première électrode formée sur la première couche semi-conductrice ; et
une seconde électrode formée sur la seconde couche semi-conductrice.

3. Dispositif émetteur de surface selon la revendication 1, comprenant en outre :
une première électrode formée sur la première couche de réflexion ; et
une seconde électrode formée sur la seconde couche semi-conductrice.

4. Dispositif d'émission en surface selon la revendication 1, comprenant en outre :
une première électrode formée sur la première couche semi-conductrice ou la première couche de réflexion ; et
une seconde électrode formée sur la seconde couche de réflexion.

5. Dispositif d'émission en surface selon la revendication 1, dans lequel la région de constriction de lumière comporte une région qui est oxydée vers l'intérieur à partir d'une surface latérale de la forme en mésa.

6. Dispositif d'émission en surface selon la revendication 1, dans lequel la première couche de réflexion ou la seconde couche de réflexion comporte du GaAs et de l'AlGaAs qui sont les seconds matériaux cristallins, le GaAs et l'AlGaAs étant stratifiés l'un sur l'autre.

7. Dispositif d'émission en surface selon la revendication 6, dans lequel la région de constriction de lumière est formée par oxydation d'une partie d'AlAs insérée entre le GaAs et l'AlGaAs.

8. Dispositif d'émission en surface selon la revendication 6, dans lequel la région de constriction de lumière est formée à une position séparée de la couche d'émission de lumière par un cycle de la première couche de réflexion ou de la seconde couche de réflexion ou plus.

9. Procédé permettant de fabriquer un dispositif émetteur de surface comprenant :
la formation d'une première couche de réflexion (3) ;
la formation d'une première couche semi-conductrice (4) ;
la formation d'une couche d'émission de lumière (5) ;
la formation d'une seconde couche semi-conductrice (7) ;
la formation d'une seconde couche de réflexion (8) sur la couche semi-conductrice ; dans lequel
la première couche semi-conductrice, la seconde couche semi-conductrice ou les deux comportent un premier matériau cristallin ;
la première couche de réflexion, la seconde couche de réflexion ou les deux comportent un second matériau cristallin dont une constante de réseau ou une structure cristalline est différente de celle du premier matériau cristallin et qui présente en outre une forme de mésa ; et
le procédé comprend :
la formation d'une région de constriction de lumière (820) qui commande un confinement optique dans une partie de la première couche de réflexion, de la seconde couche de réflexion ou des deux ; **caractérisé par**
la formation d'une couche de jonction tunnel (6) entre la première couche semi-conductrice et la couche d'émission de lumière ou entre la couche d'émission de lumière et la seconde couche semi-conductrice ; et
la formation d'une région de constriction de courant (60) autour de la couche de jonction tunnel.

10. Procédé permettant de fabriquer le dispositif d'émission en surface selon la revendication 9, dans lequel
la première couche de réflexion, la seconde couche de réflexion ou les deux comportent du GaAs et de l'AlGaAs qui sont les seconds matériaux cristallins, le GaAs et l'AlGaAs étant stratifiés l'un sur l'autre, et
la région de constriction de lumière est formée par l'oxydation d'une partie de l'AlAs, insérée entre le GaAs et l'AlGaAs, exposée à partir d'une surface latérale de la forme en mésa.
